# EUROPÄISCHE PATENTSCHRIFT

(11) **EP 2 057 647 B1**
(45) Veröffentlichungstag und Bekanntmachung des Hinweises auf die Patenterteilung: **28.08.2019**
(21) Anmeldenummer: 07817799.5
(22) Anmeldetag: 14.11.2007
(51) Int. Cl.: H01G 4/232, H01G 4/12, H01G 4/30, H05K 3/32

(54) **BAUELEMENT-ANORDNUNG**
COMPONENT ASSEMBLY
ENSEMBLE COMPOSANT

(30) Priorität: 16.11.2006 DE 102006054085
(43) Veröffentlichungstag der Anmeldung: 13.05.2009
(73) Patentinhaber: TDK Electronics AG, 81671 München (DE)
(72) Erfinder: WISCHNAT, Volker, 8530 Deutschlandsberg (AT)
(74) Vertreter: Epping - Hermann - Fischer
(86) Internationale Anmeldenummer: PCT/DE2007/002079
(87) Internationale Veröffentlichungsnummer: WO 2008/058531

(56) Entgegenhaltungen:
- DE-A1- 19 915 745
- DE-A1-102004 016 146
- JP-A- 4 278 508
- JP-A- 2000 124 059
- JP-A- 2006 216 781
- US-A1- 2003 103 320

## Beschreibung

Ein Vielschicht-Bauelement auf der Basis von Keramik ist aus der Druckschrift DE 10132798 C1 bekannt.

In JP 2006 216781 A ist eine Anordnung beschrieben, bei der elektrische Außenkontakte mit einer planen Oberfläche auf der Unterseite des Körpers eines elektrischen Bauelementes angeordnet sind. Das Bauelement ist mittels eines Leitklebers auf einem Substrat befestigt. Der Leitkleber berührt den Körper auch seitlich der Außenkontakte.

In der Druckschrift DE 10 2004 016 146 A1 wird ein Bauteil mit den Merkmalen des Oberbegriffs des Anspruchs 1 offenbart.

Aufgabe der vorliegenden Erfindung ist es, die Montage eines Vielschicht-Kondensators, insbesondere eines Keramikkondensators, mittels eines Leitklebers zu verbessern.

Diese Aufgabe wird mit dem Bauelement mit den Merkmalen des Anspruchs 1 beziehungsweise mit der Bauelement-Anordnung mit den Merkmalen des Anspruchs 5 gelöst. Ausgestaltungen ergeben sich aus den jeweiligen abhängigen Ansprüchen.

Es wird eine Bauelement-Anordnung angegeben, die ein elektrisches Bauelement mit einem Körper und ein Trägersubstrat umfasst, auf dem das Bauelement mittels einer Leitklebeschicht befestigt ist. Auf der Unterseite des Körpers sind elektrische Außenkontakte angeordnet, die eine plane Oberfläche aufweisen. Der Leitkleber berührt den Körper in mindestens einem Berührungsbereich, der frei von den elektrischen Außenkontakten ist.

Der Körper enthält vorzugsweise ein gesintertes Keramikmaterial. Es wurde festgestellt, dass der Leitkleber gut an keramischen Oberflächen haftet. Daher ist es vorteilhaft, wenn der Körper und das Trägersubstrat zusätzlich durch den Leitkleber direkt, also außerhalb der dazwischen liegenden elektrischen Außenkontakte, miteinander verbunden sind.

Verglichen mit Außenkontakten, die in einem Tauchverfahren erzeugt werden und daher eine gekrümmte Oberfläche aufweisen, zeichnen sich die Außenkontakte mit einer planen Oberfläche durch eine geringe Fertigungstoleranz insbesondere bezüglich ihrer Höhe aus. Der Abstand zwischen dem Trägersubstrat und dem Körper ist dann im Wesentlichen konstant.

Durch einen zwischen dem Trägersubstrat und dem Körper gebildeten Spalt kann der überschüssige Leitkleber geführt werden. Wie weit der Leitkleber in den Spalt vordringt, hängt von den Benetzungseigenschaften des Klebers und der Spaltgröße ab. Daher ist eine konstante Spaltgröße für die Abschätzung der optimalen Menge des Leitklebers besonders vorteilhaft.

Auf die jeweilige Außenkontaktfläche des Trägersubstrats wird eine wohl definierte Menge des Leitklebers aufgetragen, vorzugsweise durch eine Schablone aufgedruckt. Alternativ besteht die Möglichkeit, die Außenkontakte des Bauelements mit dem Leitkleber zu bedrucken. Das Bauelement wird gegen das Trägersubstrat gepresst, wobei ein Teil des Leitklebers in den Spalt herausgedrängt wird. Die aufzudruckende Menge des Leitklebers pro Außenkontaktfläche wird so bemessen, dass beim Vordringen des überschüssigen Leitklebers in den Spalt keine Kurzschlüsse entstehen. Der Leitkleber soll daher um weniger als die Hälfte des Abstands zwischen zwei Außenkontakten vordringen. Dies kann bei Außenkontakten mit einer planaren Oberfläche besonders genau eingestellt werden.

Die Menge des Leitklebers wird so berechnet, dass durch den in den Spalt vorgedrungenen überschüssigen Leitkleber zwischen dem Trägersubstrat und dem Körper eine feste Verbindung entsteht.

Das Aushärten des Leitklebers erfolgt in einer Variante bei ca. 150°C, d. h. bei einer Temperatur, die unterhalb von üblichen Löttemperaturen liegt.

Die elektrischen Außenkontakte sind nicht in einem Tauchverfahren, sondern in einem Verfahren erzeugt, bei dem eine leitfähige Paste angeformt wird. Sie können durch Aufdrucken, beispielsweise in einem Siebdruckverfahren erzeugt werden. Die aufgetragene leitfähige Paste wird eingebrannt und gegebenenfalls durch eine Au-oder PdNi-Schicht galvanisch verstärkt. Die Außenkontakte können auch durch Aufwalzen der leitfähigen Paste mit anschließendem Einbrennen erzeugt sein.

Durch geeignete Druckverfahren wie z. B. Siebdruck können Außenkontakte hergestellt werden, die eine in hohem Maße plane Oberfläche aufweisen. Eine geringe Streuung der Schichtstärke kann somit eingehalten werden.

In einer ersten Variante wird zur Bildung von Außenkontakten auf der Unterseite des Körpers eine AgPd-Schicht aufgedruckt und eingebrannt.

In einer zweiten Variante wird eine Kupferschicht aufgedruckt und eingebrannt. Auf dieser Schicht wird danach eine Au- oder PdNi-Schicht in einem galvanischen Verfahren erzeugt.

In einer dritten Variante wird eine Sinterauflage, z. B. eine Ni-Schicht, erzeugt, indem z. B. eine Ni-Schicht auf den ungesinterten Grünkörper des Vorläufer-Bauelements vorzugsweise in einem Siebdruckverfahren aufgedruckt wird und beim anschließenden Sintern des Bauelements das Ni "aufgesintert" wird. Auf dieser Schicht wird danach eine Au- oder PdNi-Schicht in einem galvanischen Verfahren erzeugt.

Vorzugsweise wird für die Formgebung eine Schablone verwendet. Mit der Schablone wird nicht nur die Grundfläche des jeweiligen Außenkontakts, sondern auch seine Höhe vorgegeben.

Die Höhe der elektrischen Außenkontakte ist vorzugsweise zwischen 10 und 50 Mikrometer gewählt.

Alle elektrischen Außenkontakte des Bauelements sind auf der Unterseite des Körpers angeordnet.

Das Bauelement ist als ein Vielschicht-Kondensator ausgebildet.

Der Vielschicht-Kondensator umfasst abwechselnd angeordnete erste und zweite Innenelektroden, die im Körper angeordnet sind. Die ersten Innenelektroden sind mit dem ersten elektrischen Außenkontakt und die zweiten Innenelektroden mit dem zweiten elektrischen Außenkontakt leitend verbunden. Die ersten und zweiten Innenelektroden sind voneinander isoliert. Zwischen überlappenden Bereichen der ersten und zweiten Elektroden ist eine Kapazität gebildet.

Die Innenelektroden sind parallel zur Unterseite des Körpers ausgerichtet und mittels Durchkontaktierungen mit den elektrischen Außenkontakten verbunden.

Der Körper weist vorzugsweise die Form eines Quaders auf. Die Kanten des Quaders sind vorzugsweise abgerundet. Der jeweilige elektrische Außenkontakt erstreckt sich in einer Variante auf mindestens eine der abgerundeten Kanten.

Die Oberseite und zumindest planar ausgebildete Bereiche der Seitenflächen des Körpers sind frei von den elektrischen Außenkontakten. Alle elektrischen Außenkontakte des Bauelements sind auf der Unterseite des Körpers angeordnet. Somit kann Material eingespart werden, was insbesondere bei Pd-haltigen Außenkontakten von Vorteil ist.

Der Leitkleber enthält Epoxid-Harz, das mit leitfähigen Partikeln, beispielsweise Ag und/oder Cu, gefüllt ist.

Das Material der Außenkontakte ist so gewählt, dass für eine gute Haftung zwischen Leitkleber und Außenkontakt gesorgt wird. In einer vorteilhaften Variante weisen die elektrischen Außenkontakte eine Schicht auf, die Palladium, Nickel-Palladium, Silber-Palladium oder ein anderes Edelmetall enthält. Palladium begünstigt die Haftung des Epoxid-Harzes. Die elektrischen Außenkontakte können außerdem eine weitere Schicht umfassen, die vorzugsweise Kupfer enthält. Diese Schicht, die bereits vorstehend erwähnt wurde, ist zwischen dem Körper und der Pd-haltigen Schicht angeordnet und dient als eine elektrisch leitende Haftvermittlungsschicht.

Die Außenkontakte können jeweils mindestens eine Aussparung oder Öffnung aufweisen. Dadurch wird ein Hohlraum gebildet, der mit Leitkleber ausgefüllt wird. Durch die Aussparung im Außenkontakt wird eine zusätzliche Kontaktfläche zwischen dem Leitkleber und dem Körper erzielt. Der Hohlraum mündet in einer Variante in den vorstehend erwähnten Spalt. In einer weiteren Variante ist der Hohlraum vom Spalt isoliert.

Die Bauelement-Anordnung wird nun anhand von schematischen und nicht maßstabgetreuen Figuren erläutert. Es zeigen:
Figuren 1A, 1B eine Bauelement-Anordnung mit einem auf einem Trägersubstrat montierten Bauelement in einem ersten und zweiten Längsschnitt;
Figuren 1C, 1D das Bauelement gemäß den Figuren 1A, 1B in einem ersten und zweiten Querschnitt;
Figuren 2A, 2B in Längsschnitt und Querschnitt ein Vielschicht-Bauelement, bei dem die Innenelektroden senkrecht zu elektrischen Außenkontakten des Bauelements ausgerichtet sind;
Figuren 3A, 3B in Längsschnitt und Querschnitt ein Vielschicht-Bauelement, bei dem die Innenelektroden parallel zu elektrischen Außenkontakten des Bauelements ausgerichtet sind;
Figuren 4A, 4B jeweils eine Draufsicht auf einen Außenkontakt mit Aussparung;
Figur 5 einen Außenkontakt mit zwei Schichten.

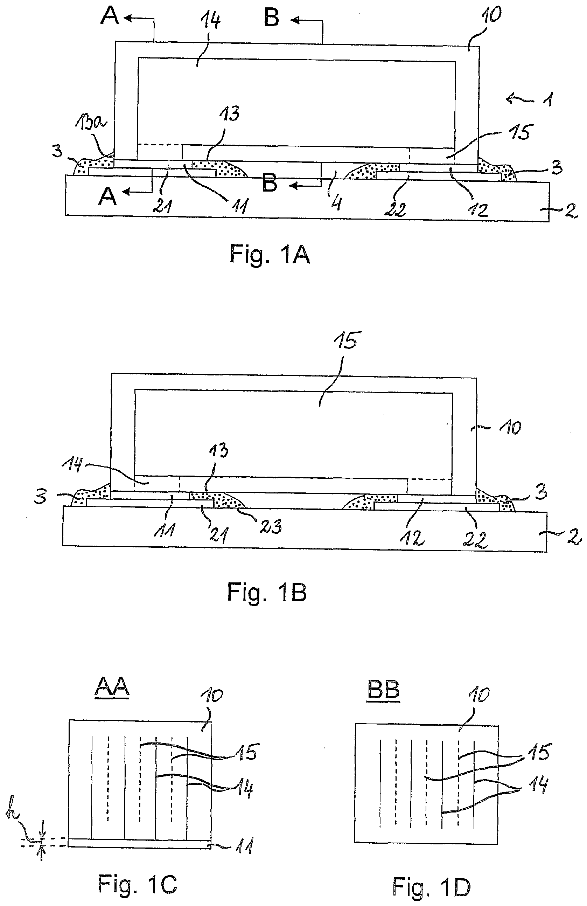

In Figuren 1A, 1B sind verschiedene Ansichten einer Bauelement-Anordnung gezeigt. Diese Anordnung umfasst ein SMDfähiges elektrisches Bauelement 1, das auf einem Trägersubstrat 2 montiert ist. SMD steht für Surface Mounted Device.

Das Bauelement 1 umfasst einen Körper 10, auf dessen Unterseite ein erster und zweiter elektrischer Außenkontakt 11, 12 angeordnet ist. Die Höhe h der Außenkontakte ist vorzugsweise zwischen 10 und 50 Mikrometer gewählt. Die Außenkontakte weisen eine plane Oberfläche auf, die den Außenkontaktflächen des Trägersubstrats zugewandt ist.

Auf der Oberseite des Trägersubstrats 2 ist eine erste und zweite Außenkontaktfläche 21, 22 angeordnet. Der Körper 10 ist mit dem Trägersubstrat 2 im Bereich der Außenkontakte 11, 12 durch einen Leitkleber 13 fest verbunden. Der Leitkleber 3 berührt den Körper 10 in einem Berührungsbereich 13 und das Trägersubstrat 2 in einem Berührungsbereich 23.

Zwischen dem Körper 10 und dem Trägersubstrat 2 ist ein enger Spalt 4 gebildet, der teilweise mit dem Leitkleber 3 gefüllt ist.

Der Leitkleber 3 bildet eine feste Verbindung zwischen dem Körper 10 und dem Trägersubstrat 2, deren Querschnitt denjenigen der Außenkontakte 11, 12 und der Außenkontaktflächen 21, 22 übersteigt. Somit kann eine besonders gute Klebefestigkeit des Bauelements am Träger gewährleistet werden.

Der Berührungsbereich 13 ist zwischen zwei elektrischen Außenkontakten 21, 22, auf der Unterseite des Körpers 10 angeordnet. Außerdem ist ein weiterer Berührungsbereich 13a vorhanden, der an der Seitenfläche der Körpers 10 angeordnet ist.

Im Körper 10 ist ein Stapel von ersten Innenelektroden 14 angeordnet, die jeweils mit dem ersten Außenkontakt 11 leitend verbunden sind. Im Körper 10 ist ein Stapel von zweiten Innenelektroden 15 angeordnet, die jeweils mit dem zweiten Außenkontakt 12 leitend verbunden sind.

In der Figur 1C ist ein Querschnitt AA und in der Figur 1D ein Querschnitt BB des Bauelements 1 gezeigt.

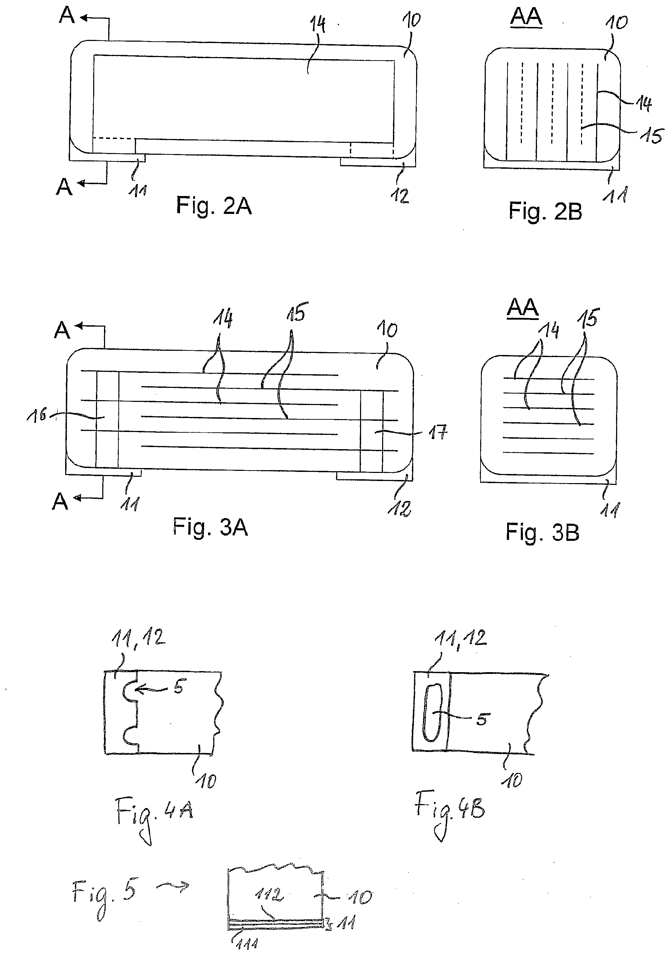

In den Figuren 2A, 2B sind verschiedene Ansichten eines elektrischen Vielschicht-Bauelements gezeigt, das im Unterschied zu der vorhergehenden Variante einen Körper mit abgerundeten Kanten aufweist. Die Kanten sind beispielsweise durch Scheuern abgerundet.

Der jeweilige elektrische Außenkontakt 11, 12 erstreckt sich in Längsrichtung auf die abgerundete Kante, die zwischen der Unterseite und einer ersten oder zweiten Stirnseite des Körpers gebildet ist. Obwohl die Form der Außenkontakte an die abgerundeten Kanten angepasst ist, ist die untere Oberfläche der Außenkontakte plan.

In den Figuren 3A, 3B sind verschiedene Ansichten eines weiteren elektrischen Vielschicht-Bauelements gezeigt. In diesem Fall sind erfindungsgemäß die ersten Innenelektroden 14 mittels einer im Körper 10 angeordneten ersten Durchkontaktierung 16 miteinander und mit dem ersten Außenkontakt 11 des Bauelements verbunden. Die zweiten Innenelektroden 15 mittels einer im Körper 10 angeordneten zweiten Durchkontaktierung 17 miteinander und mit dem zweiten Außenkontakt 12 des Bauelements verbunden.

In Figur 4A ist ein Außenkontakt 11, 12 mit zwei Aussparungen 5 und in Figur 4B ein Außenkontakt mit einer Aussparung in Form einer Öffnung gezeigt. Mehrere Öffnungen pro Außenkontakt kommen auch in Betracht.

Figur 5 zeigt einen Außenkontakt 11, der eine erste Schicht 111 und eine zweite Schicht 112 aufweist. Die erste Schicht 111 enthält vorzugsweise Silber-Palladium. Die zweite Schicht 112, die zwischen der ersten Schicht 111 und dem Körper 10 angeordnet ist, enthält vorzugsweise metallisches Kupfer.

Die erste Schicht 111 kann z. B. metallisches Pd, PdNi oder Au enthalten, das vorzugsweise galvanisch aufgetragen wird. Die zweite Schicht 112 kann z. B. metallisches Cu, Ag oder AgPd enthalten, das in einer Variante durch Siebdruck aufgetragen wird.

In einer Variante ist es möglich, auf die Schicht 111 zu verzichten, wenn beispielsweise die Schicht 112 AgPd enthält. Diese Schicht wird vorzugsweise durch Siebdruck aufgetragen.

### Bezugszeichenliste

- 1: Bauelement
- 10: Körper
- 11, 12: elektrische Außenkontakte des Bauelements
- 13: Berührungsbereich
- 14, 15: Innenelektroden
- 2: Trägersubstrat
- 21, 22: Außenkontaktflächen des Trägersubstrats
- 23: Berührungsbereich
- 3: Leitkleber
- 4: Spalt
- 5: Aussparung
- h: Höhe der Außenkontakte 11, 12

## Patentansprüche

1. Bauelement (1)
- mit einem Körper (10) mit darin abwechselnd angeordneten ersten und zweiten Innenelektroden (14, 15) eines Vielschicht-Kondensators und
- mit elektrischen Außenkontakten (11, 12), umfassend einen ersten elektrischen Außenkontakt (11) und einen zweiten elektrischen Außenkontakt (12), wobei alle elektrischen Außenkontakte (11, 12) auf einer Unterseite des Körpers (10) angeordnet sind, so dass eine Oberseite und zumindest planar ausgebildete Bereiche der Seitenflächen des Körpers (10) frei von elektrischen Außenkontakten (11, 12) sind,
- wobei die ersten und zweiten elektrischen Außenkontakte (11, 12) durch eine aufgedruckte oder aufgewalzte und eingebrannte Schicht gebildet sind, eine plane Oberfläche aufweisen und die ersten Innenelektroden (14) mit dem ersten elektrischen Außenkontakt (11) und die zweiten Innenelektroden (15) mit dem zweiten elektrischen Außenkontakt (12) leitend verbunden sind, **dadurch gekennzeichnet, dass**
- die ersten und zweiten Innenelektroden (14, 15) parallel zur Unterseite des Körpers (10) ausgerichtet und mittels Durchkontaktierungen (16, 17) mit den elektrischen Außenkontakten (11, 12) verbunden sind,
- die ersten Innenelektroden (14) mittels einer in dem Körper angeordneten ersten Durchkontaktierung (16) miteinander und mit dem ersten Außenkontakt (11) verbunden sind und
- die zweiten Innenelektroden (15) mittels einer in dem Körper angeordneten zweiten Durchkontaktierung (17) miteinander und mit dem zweiten Außenkontakt (12) verbunden sind.

2. Bauelement nach Anspruch 1, bei dem die ersten und zweiten elektrischen Außenkontakte (11, 12) eine Schicht (111) aufweisen, die Silber-Palladium enthält.

3. Bauelement nach Anspruch 2, bei dem ersten und zweiten elektrischen Außenkontakte (11, 12) eine kupferhaltige weitere Schicht (112) aufweisen, die zwischen dem Körper (10) und der Schicht, die Silber-Palladium enthält, angeordnet ist.

4. Bauelement nach einem der Ansprüche 1 bis 3, bei dem die ersten und zweiten elektrischen Außenkontakte (11, 12) jeweils mindestens eine Aussparung aufweisen.

5. Bauelement-Anordnung, bei der
- ein elektrisches Bauelement (1) nach einem der Ansprüche 1 - 4 auf einem Trägersubstrat (2) angeordnet ist,
- eine erste und zweite Außenkontaktfläche (21, 22) auf einer Oberseite des Trägersubstrats (2) angeordnet sind,
- das Bauelement (1) mittels eines Leitklebers (3) auf dem Trägersubstrat (2) befestigt ist, wobei der Leitkleber (3) den Körper (10) in einem Berührungsbereich (13) berührt, der frei von den ersten und zweiten elektrischen Außenkontakten (11, 12) ist, und das Trägersubstrat (2) in einem weiteren Berührungsbereich (23) berührt, der frei von den Außenkontaktflächen (21, 22) ist.

6. Bauelement-Anordnung nach Anspruch 5, bei der die Höhe (h) der ersten und zweiten elektrischen Außenkontakte (11, 12) 50 Mikrometer nicht überschreitet.

7. Bauelement-Anordnung nach einem der Ansprüche 5 oder 6, bei der die ersten und zweiten elektrischen Außenkontakte (11, 12) jeweils mindestens eine Aussparung aufweisen, die mit Leitkleber (3) gefüllt ist.

## Claims

1. Component (1)
- with a body (10) with first and second internal electrodes (14, 15), arranged alternately therein, of a multilayer capacitor
and
- with electrical external contacts (11, 12), comprising a first electrical external contact (11) and a second electrical external contact (12), all the electrical external contacts (11, 12) being arranged on a bottom of the body (10), such that a top and at least regions of planar configuration of the side faces of the body (10) are free of electrical external contacts (11, 12),
- the first and second electrical external contacts (11, 12) being formed by a printed- or rolled-on and stoved layer and having a plane surface and the first internal electrodes (14) being conductively connected with the first electrical external contact (11) and the second internal electrodes (15) being conductively connected with the second electrical external contact (12),
**characterized in that**
- the first and second internal electrodes (14, 15) are oriented in parallel with the bottom of the body (10) and are connected to the electrical external contacts (11, 12) by means of vias (16, 17),
- the first internal electrodes (14) are connected together and to the first external contact (11) by means of a first via (16) arranged in the body and
- the second internal electrodes (15) are connected together and with the second external contact (12) by means of a second via (17) arranged in the body.

2. Component according to Claim 1, in which the first and second electrical external contacts (11, 12) have a layer (111) containing silver-palladium.

3. Component according to Claim 2, in which first and second electrical external contacts (11, 12) have a copper-containing further layer (112), which is arranged between the body (10) and the layer containing silver-palladium.

4. Component according to one of Claims 1 to 3, in which the first and second electrical external contacts (11, 12) each have at least one recess.

5. Component assembly, in which
- an electrical component (1) according to one of Claims 1-4 is arranged on a carrier substrate (2),
- a first and a second external contact surface (21, 22) is arranged on a top of the carrier substrate (2),
- the component (1) is fastened to the carrier substrate (2) using a conductive adhesive (3), the conductive adhesive (3) being in physical contact with the body (10) in a physical contact region (13) which is free of the first and second electrical external contacts (11, 12), and being in physical contact with the carrier substrate (2) in a further physical contact region (23) which is free of the external contact surfaces (21, 22).

6. Component assembly according to Claim 5, in which the height (h) of the first and second electrical external contacts (11, 12) does not exceed 50 micrometres.

7. Component assembly according to one of Claims 5 or 6, in which the first and second electrical external contacts (11, 12) each have at least one recess, which is filled with conductive adhesive (3).

## Revendications

1. Composant (1)
- présentant un corps (10) pourvu de premières et de deuxièmes électrodes internes (14, 15) d'un condensateur multicouche, agencées en alternance en son sein
et
- présentant des contacts électriques externes (11, 12), comprenant un premier contact électrique externe (11) et un deuxième contact électrique externe (12), tous les contacts électriques externes (11, 12) étant agencés sur une face inférieure du corps (10) de telle sorte qu'une face supérieure et au moins des zones conçues de manière plane des faces latérales du corps (10) sont exemptes de contacts électriques externes (11, 12),
- les premiers et les deuxièmes contacts électriques externes (11, 12) étant formés par une couche imprimée ou laminée ou gravée, présentant une surface plane et les premières électrodes internes (14) étant reliées de manière conductrice au premier contact électrique externe (11) et les deuxièmes électrodes internes (15) étant reliées de manière conductrice au deuxième contact électrique externe (12), **caractérisé en ce que**
- les premières et les deuxièmes électrodes internes (14, 15) sont orientées parallèlement à la face inférieure du corps (10) et reliées aux contacts électriques externes (11, 12) à l'aide de connexions transversales (16, 17),
- les premières électrodes internes (14) sont reliées les unes aux autres et au premier contact externe (11) au moyen d'une première connexion transversale (16) agencée dans le corps et
- les deuxièmes électrodes internes (15) sont reliées les unes aux autres et au deuxième contact externe (12) au moyen d'une deuxième connexion transversale (17) agencée dans le corps.

2. Composant selon la revendication 1, dans lequel les premiers et les deuxièmes contacts électriques externes (11, 12) présentent une couche (111) qui contient de l'argent-palladium.

3. Composant selon la revendication 2, dans lequel les premiers et les deuxièmes contacts électriques externes (11, 12) présentent une autre couche (112) contenant du cuivre, qui est agencée entre le corps (10) et la couche qui contient de l'argent-palladium.

4. Composant selon l'une quelconque des revendications 1 à 3, dans lequel les premiers et les deuxièmes contacts électriques externes (11, 12) présentent à chaque fois au moins un évidement.

5. Ensemble composant, dans lequel
- un composant électrique (1) selon l'une quelconque des revendications 1-4 est agencé sur un substrat support (2),
- une première et une deuxième surface (21, 22) de contact externes sont agencées sur une face supérieure du substrat support (2),
- le composant (1) est fixé sur le substrat support (2) au moyen d'un adhésif conducteur (3), l'adhésif conducteur (3) étant en contact avec le corps (10) dans une zone de contact (13) qui est exempte de premiers et de deuxièmes contacts électriques externes (11, 12) et en contact avec le substrat support (2) dans une autre zone de contact (23) qui est exempte des surfaces (21, 22) de contact externes.

6. Ensemble composant selon la revendication 5, dans lequel la hauteur (h) des premiers et des deuxièmes contacts électriques externes (11, 12) ne dépasse pas 50 µm.

7. Ensemble composant selon l'une quelconque des revendications 5 ou 6, dans lequel les premiers et les deuxièmes contacts électriques externes (11, 12) présentent à chaque fois au moins un évidement, qui est rempli d'adhésif conducteur (3).
